# EUROPEAN PATENT APPLICATION

(11) **EP 3 531 515 A1**
(43) Date of publication of application: **28.08.2019**
(21) Application number: 19155265.2
(22) Date of filing: 04.02.2019
(51) Int. Cl.: H01S 5/00, H01S 5/40, G02B 27/09, G03B 21/20, H01S 5/022

(54) **LIGHT SOURCE APPARATUS, ILLUMINATOR, AND PROJECTOR**

(30) Priority: 06.02.2018 JP 2018019129
(71) Applicant: Seiko Epson Corporation, Tokyo 160-8801 (JP)
(72) Inventor: AKIYAMA, Koichi, Nagano, 392-8502 (JP)
(74) Representative: Hoffmann Eitle

(57) **Abstract**

A light source apparatus 20 includes a first laser light emitter 20R that emits red light, a second laser light emitter 20G that emits green light, a third laser light emitter 20B that emits blue light, and a light combiner 21 into which the red light emitted from the first laser light emitter, the green light emitted from the second laser light emitter, and the blue light emitted from the third laser light emitter enter and that combines the incident red light, green light, and blue light with one another and outputs the combined light. The first laser light emitter includes L red light emitting devices. The second laser light emitter includes M green light emitting devices. The third laser light emitter includes N blue light emitting devices. L, M, and N are each an integer greater than or equal to one, and N is smaller than L and M. An illuminator 2 includes said light source apparatus 20 and a projector 1 includes said illuminator.

## Description

### BACKGROUND

### 1. Technical Field

The present invention relates to a light source apparatus, an illuminator, and a projector.

### 2. Related Art

In recent years, a laser light source has received attention as a light source apparatus for a projector.

WO2015/056381 discloses a light source apparatus for a projector, and the light source apparatus includes, as each of array light sources corresponding to RGB, a plurality of arranged CAN packages in each of which one laser light emitting device is encapsulated in a single package. In the present specification, the CAN package refers to a structure in which one laser light emitting device is encapsulated in a single package (encapsulating structure).

JP-A-2013-51375 discloses an array light source using a multi-emitter package in which a plurality of laser light emitting devices mounted on a substrate are encapsulated in a single package. In the present specification, the multi-emitter package refers to a structure in which a plurality of laser light emitting devices are encapsulated in a single package. In general, at least 20 laser light emitting devices are arranged in a matrix (two dimensionally in horizontal and vertical directions) in a multi-emitter package.

In general, in a case where a large number of laser light emitting devices are necessary, a multi-emitter package is superior to a CAN package in terms of cost. That is, in a CAN package, an encapsulating member is formed for each of a plurality of laser light emitting devices, and a base member for mounting the plurality of CAN packages is also necessary, resulting in a relatively high necessary part cost. In contrast, in a multi-emitter package, only one encapsulating structure is necessary for a plurality of light emitting devices, and the encapsulating structure also serves as the base member on which the light emitting devices are mounted, whereby the number of parts is small as a whole, resulting in a relatively low cost.

Therefore, in the projector including a large number of laser light emitting devices disclosed in WO2015/056381, a study of replacement of the CAN-packaged light sources with a multi-emitter-packaged light source is underway.

The comparison described above between the cost of the multi-emitter package and the cost of the CAN package also involves the number of encapsulated light emitting devices. A multi-emitter package encapsulating too small a number of light emitting devices could be inferior to CAN packages in terms of cost. In other words, to achieve cost superiority, a certain number of light emitting devices need to be encapsulated in a multi-emitter package. It is therefore typical in the case of a multi-emitter package that about 20 laser light emitting devices are encapsulated in one package. This applies to each of the RGB light sources.

Further, the light emission efficiency of a current laser light emitting device varies on an emitted light color basis, and a blue laser light emitting device has the highest light emission efficiency. Comparison in terms of power shows that the power of the light emitted from a blue laser light emitting device is at least twice the power of the light emitted from a green laser light emitting device or the power of the light emitted from a red laser light emitting device. Use of a multi-emitter package as each of the RGB light sources in the projector disclosed in WO2015/056381 therefore causes excessive power of the light emitted from the blue light source, resulting in a difficulty in producing white light having an appropriate white balance.

### SUMMARY

An advantage of some aspects of the invention is to provide a light source apparatus, an illuminator, and a projector in which a multi-emitter package is used and which achieve an appropriate white balance.

According to a first aspect of the invention, a light source apparatus is is provided. The light source apparatus includes a first laser light emitter that emits red light, a second laser light emitter that emits green light, a third laser light emitter that emits blue light, and a light combiner that the red light emitted from the first laser light emitter, the green light emitted from the second laser light emitter, and the blue light emitted from the third laser light emitter enter and that combines the incident red light, green light, and blue light with one another and outputs the combined light. The first laser light emitter includes L red light emitting devices . The second laser light emitter includes M green light emitting devices. The third laser light emitter includes N blue light emitting devices. L, M, and N are each an integer greater than or equal to one, and N is smaller than L and M.

In the light source apparatus according to the first aspect, the number of blue light emitting devices is smaller than the number of red light emitting devices and the number of green light emitting devices. This configuration prevents the power of the blue light from being excessive.

In the aspect described above, it is preferable that in the first laser light emitter, the L red light emitting devices are encapsulated in a single encapsulating structure, and that in the second laser light emitter, the M green light emitting devices are encapsulated in a single encapsulating structure.

According to the configuration described above, the first and second laser light emitters can each be configured in the form of the multi-emitter package.

In the aspect described above, it is preferable that in the third laser light emitter, N is an integer greater than or equal to two, that the N blue light emitting devices include a first blue light emitting device and a second light emitting device, that the first blue light emitting device is encapsulated in a first encapsulating structure, and that the second blue light emitting device is encapsulated in a second encapsulating structure that is so formed as to be separate from the first encapsulating structure.

According to the configuration described above, the third laser light emitter can be configured in the form of the CAN package.

In the aspect described above, it is preferable that the third laser light emitter further includes an anamorphic system that a blue light beam emitted from each of the blue light emitting devices enters.

According to the configuration described above, the anamorphic system allows the cross section of the blue light beam emitted from the blue light emitting device to have an aspect ratio of about one.

In the aspect described above, it is preferable that the light source apparatus further includes a light collection lens that the light having exited out of the light combiner enters and a diffuser on which the light collected by the light collection lens is incident.

In the configuration described above, for example, when the sizes of illumination areas illuminated with the red light, the green light, and the blue light and formed on the light incident surface of the light collection lens are equal to each other, the angles of incidence of the color light fluxes (blue light, red light, and green light) incident on the diffuser are distributed over roughly the same range. The red light, the green light, and the blue light diffused when passing through the diffuser can then have roughly the same light flux width (thickness). The red light, the green light, and the blue light having the same light flux width can be combined with one another to produce white illumination light having reduced color unevenness.

According to a second aspect of the invention, an illuminator is provided. The illuminator includes the light source apparatus according to the first aspect and a homogenizing illumination system that illumination light outputted from the light source apparatus enters.

The illuminator according to the second aspect can produce illumination light having a homogenized intensity distribution.

According to a third aspect of the invention, a projector is provided. The projector includes the illuminator according to the second aspect, a light modulator that modulates light from the illuminator in accordance with image information to form image light, and a projection optical apparatus that projects the image light.

The projector according to the third aspect, which includes the illuminator that outputs light having reduced color unevenness, can display a good-quality image having a small amount of decrease in image quality due to color unevenness.

### BRIEF DESCRIPTION OF THE DRAWINGS

The invention will be described with reference to the accompanying drawings, wherein like numbers reference like elements.
Fig. 1 shows a schematic configuration of a projector according to a first embodiment.
Fig. 2 shows a schematic configuration of an illuminator.
Fig. 3 is a perspective view showing the configuration of a red light emitter.
Fig. 4 is a perspective view showing the configuration of key parts of a red light emitting device.
Fig. 5 is a perspective view showing the configuration of a blue light emitter.
Fig. 6 diagrammatically shows a combined light beam flux that enters a light collection lens.
Fig. 7 shows a schematic configuration of an illuminator according to a second embodiment.
Fig. 8 shows a schematic configuration of a projector according to a third embodiment.
Fig. 9 shows a schematic configuration of a collimator system according to a variation.

### DESCRIPTION OF EXEMPLARY EMBODIMENTS

Embodiments of the invention will be described below in detail with reference to the drawings.

An example of a projector according to one of the embodiments will first be described.

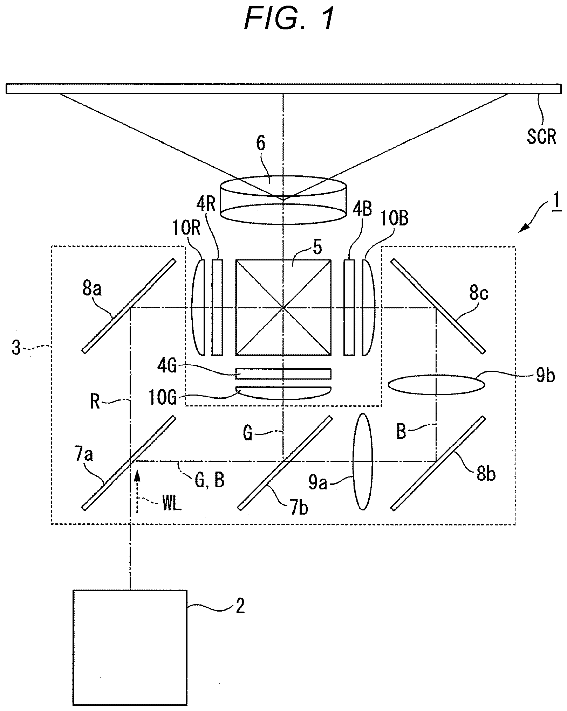

Fig. 1 shows a schematic configuration of the projector according to the present embodiment.

A projector 1 according to the present embodiment is a projection-type image display apparatus that displays color video images on a screen SCR, as shown in Fig. 1. The projector 1 includes an illuminator 2, a color separation system 3, light modulators 4R, 4G, and 4B, a light combining system 5, and a projection optical apparatus 6.

The color separation system 3 separates illumination light WL into red illumination light R, green illumination light G, and blue illumination light B. The color separation system 3 includes dichroic mirrors 7a and 7b, total reflection mirrors 8a, 8b, and 8c, and first and second relay lenses 9a, 9b. Red, green, and blue are hereinafter collectively referred to as RGB in some cases.

The dichroic mirror 7a separates the illumination light WL from the illuminator 2 into the red illumination light R and the other light (green illumination light G and blue illumination light B). The dichroic mirror 7a transmits the red illumination light R and reflects the other light. The dichroic mirror 7b reflects the green illumination light G and transmits the blue illumination light B.

The total reflection mirror 8a reflects the red illumination light R toward the light modulator 4R. The total reflection mirrors 8b and 8c guide the blue illumination light B to the light modulator 4B. The green illumination light LG is reflected off the dichroic mirror 7b toward the light modulator 4G.

The first relay lens 9a and the second relay lens 9b are disposed in the optical path of the blue illumination light B and on the downstream side of the dichroic mirror 7b.

The light modulator 4R modulates the red illumination light R in accordance with image information to form red image light. The light modulator 4G modulates the green illumination light G in accordance with image information to form green image light. The light modulator 4B modulates the blue illumination light B in accordance with image information to form blue image light.

The light modulators 4R, 4G, and 4B are each formed, for example, of a transmissive liquid crystal panel. Polarizers (not shown) are disposed on the light incident side and the light exiting side of each of the liquid crystal panels.

Field lenses 10R, 10G, and 10B are disposed on the light incident side of the light modulators 4R, 4G, and 4B, respectively.

The image light fluxes from the light modulators 4R, 4G, and 4B enter the light combining system 5. The light combining system 5 combines the image light fluxes with one another and causes the combined image light to exit toward the projection system 6. The light combining system 5 is formed, for example, of a cross dichroic prism.

The projection system 6 is formed of a projection lens group, enlarges the combined image light from the light combining system 5, and projects the enlarged image light toward the screen SCR. Enlarged color video images are thus displayed on the screen SCR.

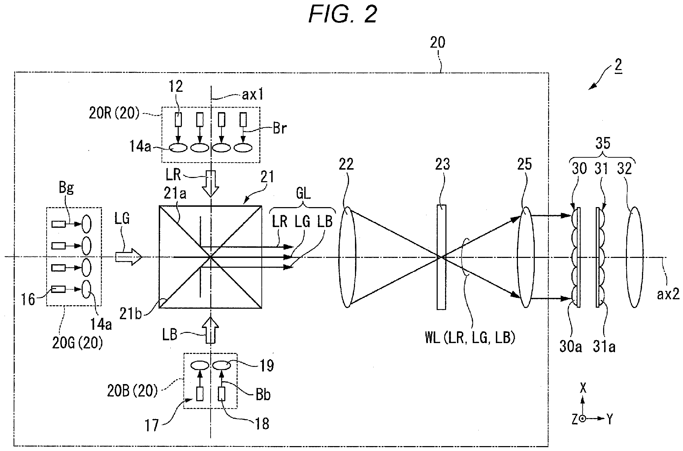

The configuration of the illuminator 2 will subsequently be described. Fig. 2 shows a schematic configuration of the illuminator 2. The illuminator 2 includes a light source apparatus 20 according to an embodiment of the invention and a homogenizing illumination system 35, as shown in Fig. 2.

The light source apparatus 20 includes a red light emitter 20R, a green light emitter 20G, a blue light emitter 20B, a light combiner 21, a light collection lens 22, a diffuser 23, and a pickup lens 25.

In the present embodiment, the red light emitter 20R, the light combiner 21, and the blue light emitter 20B are provided along an optical axis ax1 of the red light emitter 20R. The green light emitter 20G, the light combiner 21, the light collection lens 22, the diffuser 23, the pickup lens 25, and the homogenizing illumination system 35 are provided along an illumination optical axis ax2 of the illuminator 2. The optical axis ax1 and the illumination optical axis ax2 are perpendicular to each other. The optical axis of the blue light emitter 20B coincides with the optical axis of the red light emitter 20R, and the optical axis of the green light emitter 20G coincides with the illumination optical axis ax2.

The red light emitter 20R outputs red light LR formed of a plurality of red light beams Br. The green light emitter 20G outputs green light LG formed of a plurality of red light beams Bg. The blue light emitter 20B outputs blue light LB formed of a plurality of blue light beams Bb.

In the following description, an orthogonal coordinate system is used. In the orthogonal coordinate system, the direction in which the illumination light WL is outputted from the illuminator 2 is called a direction Y, the direction in which the red light LR is outputted from the red light emitter 20R is called a direction X, and the direction perpendicular to the directions X and Y and extending from the far side toward the near side with respect to the plane of view is called a direction Z.

The configuration of the red light emitter 20R will subsequently be described.

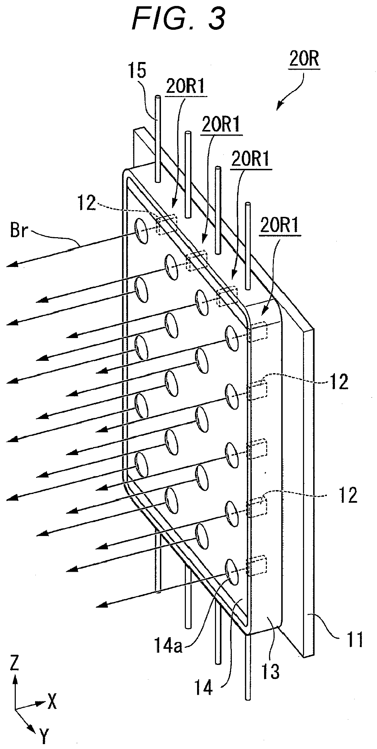

Fig. 3 is a perspective view showing the configuration of the red light emitter 20R. In Fig. 3, part of the light is omitted for clarity of the figure.

The red light emitter 20R includes a substrate 11, a plurality of red light emitting devices 12 arranged in a matrix on the substrate 11, a frame 13, a cover glass plate 14, and a plurality of electrode terminals 15, as shown in Fig. 3. The substrate 11 is made of a metal having high thermal conductivity, for example, copper.

The plurality of red light emitting devices 12 are accommodated in the space surrounded by the substrate 11, the frame 13, and the cover glass plate 14. The red light emitter 20R in the present embodiment is formed of a multi-emitter package.

The red light emitter 20R includes L red light emitting devices 12. In the red light emitter 20R, the L red light emitting devices 12 are encapsulated in a single encapsulating structure. L represents an integer greater than or equal to one, and L=20 in the present embodiment. Specifically, in the red light emitter 20R, four light emitting device rows 20R1, in each of which five red light emitting devices 12 are arranged in the Z-axis direction, are arranged in the direction Y. The red light emitting devices 12 are each formed of a semiconductor laser that emits a red light beam Br (laser light that belongs to wavelength range from 585 to 720 nm, for example).

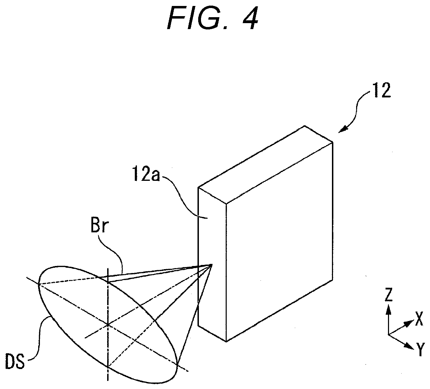

Fig. 4 shows the configuration of key parts of one of the red light emitting devices 12. The red light emitting device 12 has a light exiting surface 12a, as shown in Fig. 4. The light exiting surface 12a has a roughly oblong planar shape having short sides extending along the direction Y and long sides extending along the direction Z when viewed in the direction of the chief ray of the red light beam Br emitted from the red light emitting device 12.

The red light beam Br emitted from the red light emitting device 12 is linearly polarized light polarized in the direction parallel to the lengthwise direction of the light exiting surface 12a. Before the red light beam Br is incident on the cover glass plate 14, the divergence angle of the red light beam Br in the widthwise direction of the light exiting surface 12a is greater than the divergence angle of the red light beam Br in the lengthwise direction of the light exiting surface 12a. That is, a cross section of the red light beam Br that is the cross section parallel to a plane perpendicular to the optical axis of the red light beam Br before the incidence on the cover glass plate 14 has an elliptical shape having a major axis extending in the direction Y.

Two electrode terminals 15 are connected to each of the light emitting device rows 20R1, as shown in Fig. 3. The five red light emitting devices 12 provided in each of the light emitting device rows 20R1 are connected in series to each other, and current is supplied to the red light emitting devices 12 via the two electrode terminals 15.

The frame 13 attaches the cover glass plate 14 to the substrate 11. A plurality of collimator lenses 14a are so provided on the cover glass plate 14 as to be integrated therewith. The collimator lenses 14a are each formed of a convex lens. The collimator lenses 14a each parallelize the red light beam Br emitted from the corresponding red light emitting device 12. The collimator lenses 14a may instead be separate from the cover glass plate 14.

The thus configured red light emitter 20R outputs the red light LR formed of the parallelized light beam fluxes toward the light combiner 21. A cross-sectional shape DS parallel to a plane perpendicular to the chief ray of each of the parallelized red light beams Br has an elliptical shape having a major axis extending in the direction Y and a minor axis extending in the direction Z, as shown in Fig. 4. In the present embodiment, the red light emitter 20R corresponds to the "first laser light emitter" in the appended claims.

The configuration of the green light emitter 20G will subsequently be described. The green light emitter 20G has the same configuration as that of the red light emitter 20R except the wavelength of the light outputted from the green light emitter 20G. The same configurations as those of the red light emitter 20R therefore have the same reference characters, and the green light emitter 20G will be described with reference to Fig. 3.

The green light emitter 20G includes the substrate 11, a plurality of green light emitting devices 16 (see Fig. 2) arranged in a matrix on the substrate 11, the frame 13 (see Fig. 3), the cover glass plate 14 (see Fig. 3), and the plurality of electrode terminals 15 (see Fig. 3).

The plurality of green light emitting devices 16 are accommodated in the space surrounded by the substrate 11, the frame 13, and the cover glass plate 14. The green light emitter 20G in the present embodiment is formed of a multi-emitter package, as is the red light emitter 20R.

The green light emitter 20G includes M green light emitting devices 16. In the green light emitter 20G, the M green light emitting devices 16 are encapsulated in a single encapsulating structure. M represents an integer greater than or equal to one, and M=20 in the present embodiment. Specifically, in the green light emitter 20G, four light emitting device rows in each of which five green light emitting devices 16 are arranged in the Z-axis direction are arranged in the X-axis direction. The green light emitting devices 16 are each formed of a semiconductor laser that emits a green light beam Bg (laser light that belongs to wavelength range from 495 to 585 nm, for example) . A cross section of the green light beam Bg that is the cross section parallel to a plane perpendicular to the optical axis of the green light beam Bg before the incidence on the cover glass plate 14 has an elliptical shape.

The green light beam Bg emitted from each of the green light emitting devices 16 is parallelized by the corresponding collimator lens 14a provided on the cover glass plate 14.

The thus configured green light emitter 20G outputs the green light LG formed of the parallelized light beam fluxes toward the light combiner 21. The cross-sectional shape perpendicular to the chief ray of each of the parallelized green light beams Bg has an elliptical shape having a major axis extending in the direction X and a minor axis extending in the direction Z (see Fig. 4) . In the present embodiment, the green light emitter 20G corresponds to the "second laser light emitter" in the appended claims.

The configuration of the blue light emitter 20B will subsequently be described.

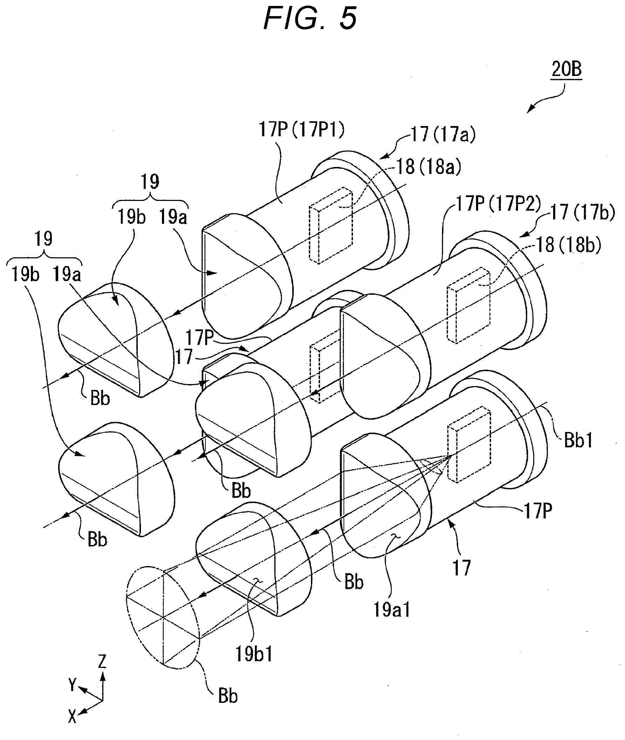

Fig. 5 is a perspective view showing the configuration of the blue light emitter 20B.

The blue light emitter 20B includes N blue light emitting packages 17 (N=4 in the present embodiment) and collimator systems 19 provided in correspondence with the blue light emitting packages 17, as shown in Fig. 5.

In the present embodiment, the blue light emitting packages 17 are each formed of a CAN-package-type semiconductor laser. Four blue light emitting packages 17 are so arranged that two of them are disposed in the direction Y and the other two are disposed in the direction Z in a plane perpendicular to the optical axis ax1, as shown in Fig. 2.

Specifically, the blue light emitting packages 17 each include one blue light emitting device 18 accommodated in a singles package (encapsulating structure) 17P. The blue light emitting device 18 emits a blue light beam Bb having a peak wavelength within a range, for example, from 460 to 480 nm.

In the present embodiment, the four blue light emitting packages 17 include a first blue light emitting package 17a and a second blue light emitting package 17b. The first blue light emitting package 17a and the second blue light emitting package 17b have the same configuration as that of the other blue light emitting packages 17.

The first blue light emitting package 17a includes a first blue light emitting device 18a encapsulated in a single package (first encapsulating structure) 17P1. The second blue light emitting package 17b includes a second blue light emitting device 18b encapsulated in a single package (second encapsulating structure) 17P2 so formed as to be separate from the first blue light emitting package 17a.

In the present embodiment, the blue light emitter 20B corresponds to the "third laser light emitter" in the appended claims, the first blue light emitting device 18a corresponds to the "first blue light emitting device" in the appended claims, and the second blue light emitting device 18b corresponds to the "second blue light emitting device" in the appended claims.

Also in each of the blue light emitting packages 17, a cross section of blue light beam Bb that is the cross section parallel to a plane perpendicular to the optical axis Bb1 of the blue light beam Bb before the blue light beam Bb enters the corresponding collimator system 19 has an elliptical shape having a major axis extending in the direction Y and a minor axis extending in the direction Z.

The collimator systems 19 are disposed on the light exiting side of the blue light emitting packages 17, for example, via an adhesive that is not shown. In the present embodiment, the collimator systems 19 each include two lenses, a first lens 19a and a second lens 19b. The first lens 19a is, for example, so provided as to block the light exit of the package 17P.

The first lens 19a has a first anamorphic surface 19a1, which parallelizes only a component of the blue light beam Bb that is the component that diverges in the major axis direction, in which the blue light beam Bb diverges by a large amount. Specifically, the first anamorphic surface 19a1 is formed of a cylindrical surface having a generatrix extending in the direction Z.

The second lens 19b has a second anamorphic surface 19b1, which parallelizes only a component of the blue light beam Bb that is the component that diverges in the minor axis direction, in which the blue light beam Bb diverges by a small amount. Specifically, the second anamorphic surface 19b1 is formed of a cylindrical surface having a generatrix extending in the direction Y.

In each of the blue light emitting packages 17, the distance between the first lens 19a (first anamorphic surface 19a1) and the second lens 19b (second anamorphic surface 19b1) along the optical path of the chief ray of the blue light beam Bb emitted from the blue light emitting device 18 is so set that the cross section of the blue light beam Bb having exited out of the light exiting surface 12a has an aspect ratio of about one. That is, in the present embodiment, the cross section of the blue light beam Bb outputted from each of the blue light emitting packages 17 is converted by the collimator system 19 from the elliptical shape into a roughly circular shape, as shown in Fig. 5. In the present embodiment, the collimator systems 19 each correspond to the "anamorphic system" in the appended claims.

Since the light emission efficiency of a semiconductor laser device varies on an emitted light color basis, the optical power of the semiconductor laser device also varies on an emitted light color basis. The light emission efficiency of each of the blue light emitting devices 18 is higher than the light emission efficiency of each of the green light emitting devices 16 and the light emission efficiency of each of the red light emitting devices 12. The optical power of each of the blue light emitting devices 18 is therefore higher than the optical power of each of the green light emitting devices 16 and the optical power of each of the red light emitting devices 12.

In a case where one light emitter includes a plurality of light emitting devices (semiconductor laser devices), the optical power value of the light emitter is equal to the sum of the optical power values of the plurality of light emitting devices.

As an example, to produce white light having a brightness of 6000 lm, the optical power values of the red light emitter 20R, the green light emitter 20G, and the blue light emitter 20B are 2 W for the red light LR, 14 W for the green light LG, and 9 W for the blue light LB, respectively. In general, the optical power of one of the blue light emitting devices 18 is about 2.25 W, the optical power of one of the green light emitting devices 16 is about 0.7 W, and the optical power of one of the red light emitting devices 12 is about 1.1 W.

Based on the optical power values and the optical power of each of the three types of light emitting device described above, the necessary minimum number of light emitting devices required to produce the white light having the brightness of 6000 lm is calculated as follows: 20 red light emitting devices 12 ; 20 green light emitting devices 16 ; and 4 blue light emitting devices 18.

Consider now a case where the same number of red light emitting devices 12, green light emitting devices 16, and blue light emitting devices 18 are employed, that is, a case where the blue light emitter 20B is configured in the form of a multi-emitter package as are the red light emitter 20R and the green light emitter 20G. In this case, the optical power of the blue light LB is undesirably excessive. That is, it is difficult to produce white light having an appropriate white balance as the illumination light WL.

In contrast, in the illuminator 2 according to the present embodiment, the number of blue light emitting devices 18 (N=4) is smaller than the number of red light emitting devices 12 (L=20) and the number of green light emitting devices 16 (M=20). This configuration prevents the optical power of the blue light LB from being excessive, whereby white illumination light WL having an appropriate white balance can be produced.

As a specific configuration, in the illuminator 2 according to the present embodiment, the red light emitter 20R and the green light emitter 20G are each configured in the form of a multi-emitter package and the blue light emitter 20B is configured in the form of a CAN package.

In a case where a large number of light emitting devices are mounted, a multi-emitter package allows efficient reduction in cost as compared with a CAB package. Therefore, in the present embodiment, the blue light emitter 20B, which includes a small number of light emitting devices so that only a small cost reduction effect is provided, employs a CAN package, and the green light emitter 20G and the red light emitter 20R, which each include a large number of light emitting devices so that a large cost reduction effect is provided, employ a multi-emitter package, whereby the cost of the light source apparatus 20 is efficiently reduced as compared with the case where the light emitters are each configured in the form of a multi-emitter package.

The light combiner 21 combines the RGB light fluxes (red light LR, green light LG, and blue light LB) outputted from the light source apparatus 20 with one another. The light combiner 21 is formed of a cross dichroic prism. The light combiner 21 includes a first dichroic mirror 21a and a second dichroic mirror 21b, which are provided between four prisms that form the cross dichroic prism.

The first dichroic mirror 21a and the second dichroic mirror 21b are so disposed as to intersect the optical axis ax1 and the illumination optical axis ax2 in such a way that the dichroic mirrors incline with respect to the optical axes by 45°. Further, the first dichroic mirror 21a and the second dichroic mirror 21b intersect with other in such a way that they incline with respect to each other by 90°.

The first dichroic mirror 21a is optically characterized in that it reflects the red light LR and transmits the green light LG and the blue light LB. The second dichroic mirror 21b is optically characterized in that it reflects the blue light LB and transmits the red light LR and the green light LG.

The thus configured light combiner 21 outputs a combined light beam flux GL containing the red light LR, the green light LG, and the blue light LB toward the light collection lens 22.

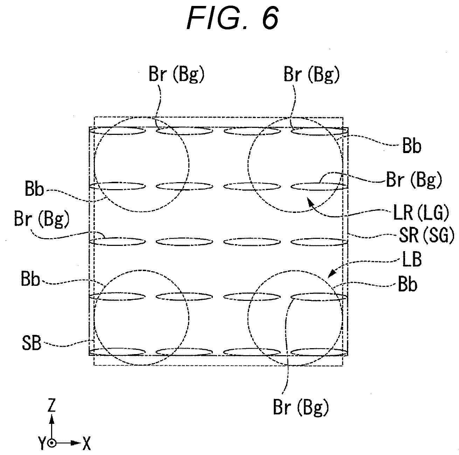

Fig. 6 diagrammatically shows the combined light beam flux GL that enters the light collection lens 22. Fig. 6 shows the combined light beam flux GL viewed along the illumination optical axis ax2 (direction -Y).

The red light LR out of the combined light beam flux GL is formed of a light beam flux containing the red light beams Br, the number of which is equal to the number of red light emitting devices 12 (20), as shown in Fig. 6. A cross section of each of the red light beams Br that is the cross section perpendicular to the illumination optical axis ax2 has an elliptical shape having a lengthwise direction extending in the direction X. The red light LR is formed of 20 red light beams Br two-dimensionally arranged in a plane parallel to the plane XZ, for example, 4 in the direction X by 5 in the direction Z.

In the present embodiment, an illumination area SR illuminated with the red light LR and formed on the light incident surface of the light collection lens 22 is specified by the line that connects the outermost shapes of the plurality of elliptical red light beams Br. That is, the illumination area illuminated with the red light LR can be considered to have a roughly rectangular outer shape.

The green light LG out of the combined light beam flux GL is formed of a light beam flux containing the green light beams Bg, the number of which is equal to the number of green light emitting devices 16 (20). A cross section of each of the green light beams Bg that is the cross section perpendicular to the illumination optical axis ax2 has an elliptical shape having a lengthwise direction extending in the direction X. The green light LG is formed of 20 green light beams Bg two-dimensionally arranged in a plane parallel to the plane XZ, for example, 4 in the direction X by 5 in the direction Z.

In the present embodiment, an illumination area SG illuminated with the green light LG and formed on the light incident surface of the light collection lens 22 is specified by the line that connects the outermost shapes of the plurality of elliptical green light beams Bg. That is, the illumination area SG illuminated with the green light LG can be considered to have a roughly rectangular outer shape.

In the present embodiment, the size of the illumination area SG illuminated with the green light LG (size of outer shape) is roughly equal to the size of the illumination area SR illuminated with the red light LR (size of outer shape), and the red light beams Br and the green light beams Bg are superimposed on each other, as shown in Fig. 6. That is, the red light LR and the green light LG are combined with each other when passing through the light combiner 21 into yellow light.

On the other hand, the blue light LB out of the combined light beam flux GL is formed of a light beam flux containing the blue light beams Bb, the number of which is equal to the number of blue light emitting packages 17 (4) . The blue light LB is formed of 4 blue light beams Bb two-dimensionally arranged in a plane parallel to the plane XZ, for example, 2 in the direction X by 2 in the direction Z. In the present embodiment, the shape of the cross section of each of the blue light beam Bb outputted from each of the blue light emitting packages 17 is converted into a roughly circular shape.

The four blue light beams Bb, which form the blue light LB, are located at the four corners of the rectangular illumination area SR illuminated with the red light LR and the rectangular illumination area SG illuminated with the green light LG. The outer shape of the illumination area SB illuminated with the blue light LB and formed on the light incident surface of the light collection lens 22 is specified by the line that connects the outermost shapes of the plurality of circular blue light beams Bb. That is, the illumination area SB illuminated with the blue light LB can be considered to have a rectangular shape having a size roughly equal to the size of the illumination area SR illuminated with the red light LR and the size of the illumination area SG illuminated with the green light LG.

The light source apparatus 20 according to the present embodiment allows the illumination areas SR, SG, and SB illuminated with the components (blue light LB, red light LR, and green light LG) of the combined light beam flux GL formed on the light collection lens 22 to be roughly equal to one another.

In the present embodiment, the light collection lens 22 causes the combined light beam flux GL to converge and impinge on the diffuser 23. The diffuser 23 is disposed on the light exiting side of the light collection lens 22. The diffuser 23 diffuses the combined light beam flux GL to prevent occurrence of speckle that compromise the display quality. In the present embodiment, the diffuser 23 corresponds to the "diffusing element" in the appended claims.

The diffuser 23 can, for example, be a known diffuser, for example, a ground glass plate, a holographic diffuser, a transparent substrate having a blasted surface, or a transparent substrate in which beads or any other scatterers are dispersed and the scatterers scatter light.

The diffuser 23 can be configured to rotate around a predetermined axis of rotation. Rotating the diffuser 23 as described above allows temporal change in the state in which the light passing through the diffuser 23 is diffused, whereby the speckle patterns change over time. The speckle patterns averaged over time are therefore recognized by a viewer, whereby the speckle noise is unlikely to be noticed as compared with a case where the diffuser 23 is not rotated.

The red light LR, the green light LG, and the blue light LB diffused by the diffuser 23 are combined with one another into the white illumination light WL. The illumination light WL is parallelized by the pickup lens 25 and enters the homogenizing illumination system 35. The homogenizing illumination system 35 includes a first lens array 30, a second lens array 31, and a superimposing lens 32.

The first lens array 30 includes a plurality of first lenslets 30a for dividing the illumination light WL having exited out of the diffuser 23 into a plurality of sub-light beam fluxes. The plurality of first lenslets 30a are arranged in an array in a plane perpendicular to the illumination optical axis ax2 of the illuminator 2.

The second lens array 31 includes a plurality of second lenslets 31a. The plurality of second lenslets 31a correspond to the plurality of first lenslets 30a. The second lens array 31, along with the superimposing lens 32, superimposes an image of each of the first lenslets 30a of the first lens array 30 in the vicinity of an image formation area of each of the light modulators 4R, 4G, and 4B.

In the configuration of the present embodiment, since the components of the combined light beam flux GL enter the common light collection lens 22, the diffusion angle of the light that exits out of the diffuser 23 is determined in accordance with the size of an area of the light collection lens 22 that is the area on which the light is incident (size of illumination area of illuminated light collection lens 22) . That is, the greater the size of the illumination area of the illuminated light collection lens 22, the greater the diffusion angle of the light that exits out of the diffuser 23.

Therefore, if the sizes of the illumination areas of the light collection lens 22 illuminated with the components of the combined light beam flux GL differ from one another, the diffusion angles of the light fluxes that exit out of the diffuser 23 undesirably differ from one another. In this case, the plurality of color light fluxes having diffusion angles different from one another are combined with one another, resulting in color unevenness of the illumination light WL.

In contrast, in the present embodiment, the sizes of the illumination areas SR, SG, and SB illuminated with the components of the combined light beam flux GL that enters the light collection lens 22 can be roughly equal to each other. In this case, since the angles of incidence of the color light fluxes (blue light LB, red light LR, and green light LG) incident on the diffuser 23 are distributed over roughly the same range, the diffusion angles of the color light fluxes that exit out of the diffuser 23 are also roughly equal to each other. That is, the red light LR, the green light LG, and the blue light LB diffused when passing through the diffuser 23 have roughly the same light flux width (thickness).

The light source apparatus 20 according to the present embodiment can therefore produce white illumination light WL having a small amount of color unevenness because the red light LR, the green light LG, and the blue light LB having the same light flux width are combined with one another. The illumination light WL is incident on the image formation area of each of the light modulators 4R, 4G, and 4B via the homogenizing illumination system 35.

As described above, the projector 1 according to the present embodiment, which includes the illuminator 2, which produces the white illumination light WL having an appropriate white balance and a small amount of color unevenness, can perform display operation with satisfactory image quality.

### Second embodiment

An illuminator according to a second embodiment will be subsequently described. The present embodiment differs from the first embodiment in terms of the configuration of the light source apparatus, and the other configurations are the same. In the present embodiment, members and configurations common to those in the first embodiment have the same reference characters and will not be described in detail.

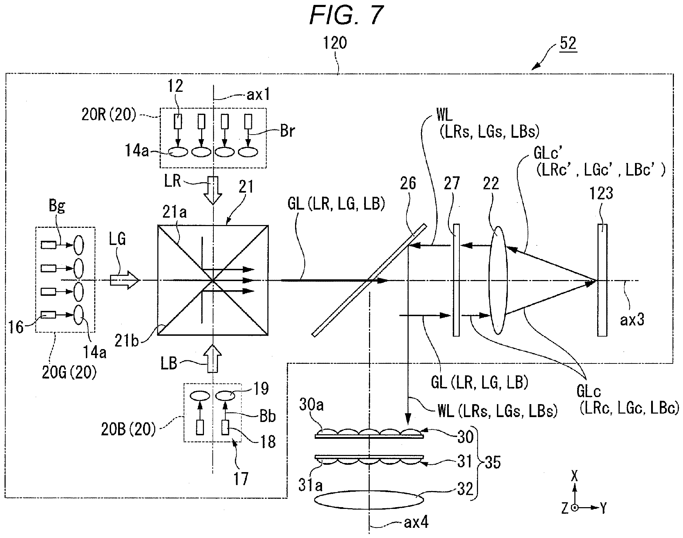

Fig. 7 shows a schematic configuration of an illuminator 52. The illuminator 52 includes a light source apparatus 120 and the homogenizing illumination system 35, as shown in Fig. 7.

The light source apparatus 120 includes the red light emitter 20R, the green light emitter 20G, the blue light emitter 20B, the light combiner 21, a polarization separation element 26, a retardation film 27, the light collection lens 22, and a diffuser 123. The green light emitter 20G, the light combiner 21, the polarization separation element 26, the retardation film 27, the light collection lens 22, and the diffuser 123 are provided along an optical axis ax3 of the green light emitter 20G. The polarization separation element 26 and the homogenizing illumination system 35 are provided along an illumination optical axis ax4 of the illuminator 52.

In the present embodiment, the light combiner 21 is configured to output the combined light beam flux GL containing the red light LR, the green light LG, and the blue light LB toward the polarization separation element 26.

In the present embodiment, the red light LR emitted from the red light emitter 20R corresponds to P-polarized light with respect to the polarization separation element 26, the green light LG emitted from the green light emitter 20G corresponds to P-polarized light with respect to the polarization separation element 26, and the blue light LB emitted from the blue light emitter 20B corresponds to P-polarized light with respect to the polarization separation element 26.

The polarization separation element 26 is so disposed as to incline by 45° with respect to the optical axis of the combined light beam flux GL. The polarization separation element 26 transmits the components (red light LR, green light LG, and blue light LB) of the combined light beam flux GL formed of the P-polarized components.

The P-polarized combined light beam flux GL (red light LR, green light LG, and blue light LB) having exited out of the polarization separation element 26 is incident on the retardation film 27. The retardation film 27 is formed of a quarter-wave plate (λ/4 plate) disposed in the optical path between the polarization separation element 26 and the diffuser 123. The combined light beam flux GL (red light LR, green light LG, and blue light LB) passes through the retardation film 27, which converts the combined light beam flux GL, for example, into right-handed circularly polarized combined light beam flux GLc (red light LRc, green light LGc, and blue light LBc), which enters the light collection lens 22.

The diffuser 123 in the present embodiment differs from the diffuser 23 in the first embodiment in that the diffuser 123 diffusively reflects the light having exited out of the light collection lens 22 toward the polarization separation element 26. The combined light beam flux GLc (red light LRc, green light LGc, and blue light LBc) is reflected off the diffuser 123, which converts the combined light beam flux GLc into left-handed circularly polarized combined light beam flux GLc' (red light LRc', green light LGc', and blue light LBc'). The components (red light LRc', green light LGc', and blue light LBc') of the circularly polarized combined light beam flux GLc' having been reflected off the diffuser 123 and having passed through the light collection lens 22 again pass through the retardation film 27 again, which converts the red light LRc', the green light LGc', and the blue light LBc' into S-polarized red light LRs, green light LGs, and blue light LBs, respectively. The red light LRs, the green light LGs, and the blue light LBs are combined with one another into the illumination light WL.

Also in the light source apparatus 120 according to the present embodiment, the illumination areas illuminated with the components (red light LRc, green light LGc, and blue light LBc) of the combined light beam flux GLc and formed on the light collection lens 22 have the same size. The angles of incidence of the color light fluxes (red light LRc, green light LGc, and blue light LBc) incident on the diffuser 123 can therefore be distributed over roughly the same range, the color light fluxes (red light LRc', green light LGc', and blue light LBc') diffusively reflected off the diffuser 123 have roughly the same diffusion angle. That is, the red light LRc' , the green light LGc', and the blue light LBc' diffused when reflected off the diffuser 123 have roughly the same light flux width (thickness), whereby the illumination light WL that is the combination of the S-polarized red light LRs, green light LGs, and blue light LBs forms white light having a small amount of color unevenness.

The light source apparatus 120 according to the present embodiment can therefore produce white illumination light WL having a small amount of color unevenness. The illumination light WL is incident on the image formation area of each of the light modulators 4R, 4G, and 4B via the homogenizing illumination system 35.

As described above, the illuminator 52 according to the present embodiment can also produce white illumination light WL having reduced color unevenness. The projector including the illuminator 52 can therefore display a good-quality image having a small amount of decrease in image quality due to color unevenness.

### Third embodiment

A projector according to a third embodiment will be subsequently described. The projector according to the present embodiment greatly differs from the projector 1 according to the first embodiment in that a micromirror-type light modulator is used. In the following description, members and configurations common to those in the first embodiment have the same reference characters, and detailed description thereof will be omitted or simplified.

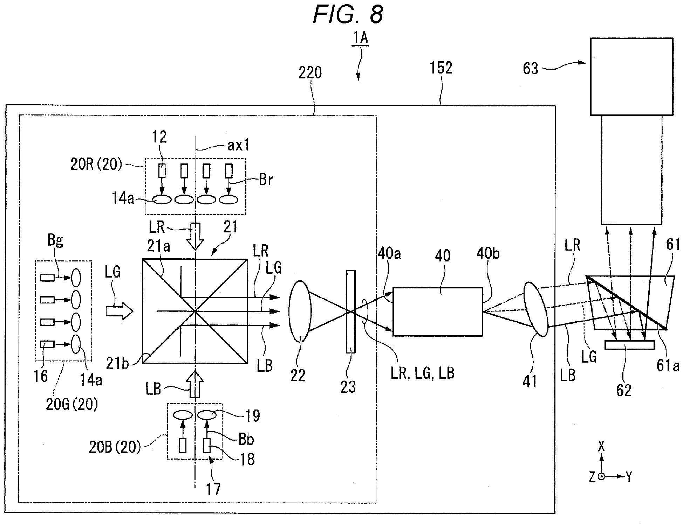

Fig. 8 shows a schematic configuration of the projector according to the present embodiment.

A projector 1A according to the present embodiment includes an illuminator 152, a total reflection prism 61, a micromirror-type light modulator 62, and a projection optical apparatus 63, as shown in Fig. 8.

The illuminator 152 includes a light source apparatus 220, a rod lens 40, and a light guiding system 41. The light source apparatus 220 includes the red light emitter 20R, the green light emitter 20G, the blue light emitter 20B, the light combiner 21, the light collection lens 22, and the diffuser 23.

In the present embodiment, the light combiner 21 causes the light fluxes from the red light emitter 20R, the green light emitter 20G, the blue light emitter 20B to enter the light collection lens 22. The light source apparatus 220 according to the present embodiment outputs the red light LR, the green light LG, and blue light LB in a time sequential manner toward the light collection lens 22. The red light LR, the green light LG, and the blue light LB outputted in a time sequential manner are incident on the diffuser 23 via the light collection lens 22.

Also in the light source apparatus 220 according to the present embodiment, the illumination areas illuminated with the color light fluxes (red light LR, green light LG, and blue light LB) and formed on the light collection lens 22 in a time sequential manner have the same size. The angles of incidence of the color light fluxes (red light LR, green light LG, and blue light LB) incident on the diffuser 23 can therefore be distributed over roughly the same range, the color light fluxes diffused when passing through the diffuser 23 can have roughly the same diffusion angle. That is, the red light LR, the green light LG, and the blue light LB diffused when passing through the diffuser 23 have roughly the same light flux width (thickness).

The light source apparatus 220 according to the present embodiment can produce white illumination light WL having reduced color unevenness because the red light LR, the green light LG, and the blue light LB having the same light flux width are combined with one another. The illumination light WL having passed through the diffuser 23 enters the rod lens 40.

The rod lens 40 has a light incident surface 40a and a light exiting surface 40b. The rod lens 40 is so configured that the light that enters the rod lens 40 via the light incident surface 40a is totally reflected off the inner surface of the rod lens 40 and then exits via the light exiting surface 40b to homogenize the intensity distribution of the light.

The light guiding system 41 cooperates with the rod lens 40 to cause the red light LR, the green light LG, and the blue light LB each having the homogenized intensity distribution to exit toward the total reflection prism 61. In the present embodiment, the rod lens 40 and the light guiding system 41 correspond to the "homogenizing illumination system" in the appended claims.

The illuminator 152 according to the present embodiment outputs the red light LR, the green light LG, and the blue light LB in a time sequential manner toward the total reflection prism 61.

The total reflection prism 61 is formed of a light transmissive member and has a total reflection surface 61a. The total reflection surface 61a is so angled that the light from the illuminator 152 (red light LR, green light LG, and blue light LB) is totally reflected toward the micromirror-type light modulator 62.

The micromirror-type light modulator 62 is formed, for example, of a digital micromirror device (DMD). A DMD includes a plurality of micromirrors arranged in a matrix. The inclination of each of the plurality of micromirrors of the DMD is changed to switch the direction in which the light incident on the DMD is reflected between the direction in which the light passes through the total reflection surface 61a and the direction in which the light is reflected off the total reflection surface 61a.

The micromirror-type light modulator 62 formed of the DMD thus sequentially modulates the color light fluxes of the illumination light WL (red light LR, green light LG, and blue light LB) outputted from the illuminator 152 to produce green image light, red image light, and blue image light. The projection optical apparatus 63 projects the green image light, the red image light, and the blue image light on a screen (not shown).

As described above, the projector 1A according to the present embodiment, when it includes the micromirror-type light modulator 62, can display a good-quality image having an appropriate white balance and having a small amount of decrease in image quality due to color unevenness.

The invention is not necessarily limited to the embodiments described above, and a variety of changes can be made thereto to the extent that the changes do not depart from the substance of the invention.

For example, the above embodiments have been described with reference to the case where the collimator system 19 in each of the blue light emitting packages 17 is formed of two lenses (first lens 19a and second lens 19b, and the collimator system may instead be formed of one lens.

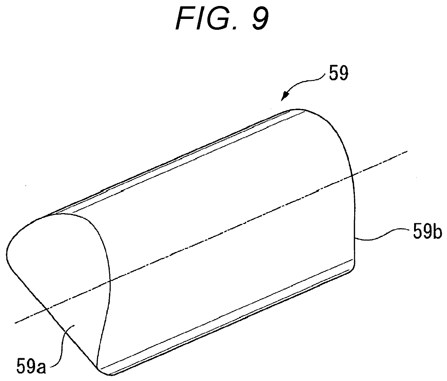

Fig. 9 shows a schematic configuration of a collimator system according to a variation.

A collimator system 59 according to the variation has a first anamorphic surface 59a and a second anamorphic surface 59b disposed on opposite sides in the direction along the optical axis of the collimator system 59, as shown in Fig. 9. The first anamorphic surface 59a is formed of a cylindrical surface having a generatrix extending in the direction Z, and the second anamorphic surface 59b is formed of a cylindrical surface having a generatrix extending in the direction Y.

The distance between the first anamorphic surface 59a and the second anamorphic surface 59b of the collimator system 59 according to the variation is so set that the cross-sectional shape of the light beam passing through the collimator system 59 has an aspect ratio of about one (circular shape).

Further, the above embodiments have been each described with reference to the case where the light source apparatus according to any of the embodiments of the invention is incorporated in a projector, but not necessarily. The light source apparatus according to any of the embodiments of the invention can also be used in a lighting apparatus, a headlight of an automobile, and other components.

## Claims

1. A light source apparatus comprising:
a first laser light emitter that emits red light;
a second laser light emitter that emits green light;
a third laser light emitter that emits blue light; and
a light combiner that the red light emitted from the first laser light emitter, the green light emitted from the second laser light emitter, and the blue light emitted from the third laser light emitter enter and that combines the incident red light, green light, and blue light with one another and outputs the combined light,
wherein the first laser light emitter includes L red light emitting devices,
the second laser light emitter includes M green light emitting devices,
the third laser light emitter includes N blue light emitting devices, and
L, M, and N are each an integer greater than or equal to one, and N is smaller than L and M.

2. The light source apparatus according to claim 1,
wherein in the first laser light emitter, the L red light emitting devices are encapsulated in a single encapsulating structure, and
in the second laser light emitter, the M green light emitting devices are encapsulated in a single encapsulating structure.

3. The light source apparatus according to any one of the preceding claims,
wherein in the third laser light emitter, N is an integer greater than or equal to two,
the N blue light emitting devices include a first blue light emitting device and a second light emitting device,
the first blue light emitting device is encapsulated in a first encapsulating structure, and
the second blue light emitting device is encapsulated in a second encapsulating structure that is so formed as to be separate from the first encapsulating structure.

4. The light source apparatus according to any one of the preceding claims,
wherein the third laser light emitter further includes an anamorphic system that a blue light beam emitted from each of the blue light emitting devices enters.

5. The light source apparatus according to any one of the preceding claims, further comprising:
a light collection lens that the light having exited out of the light combiner enters; and
a diffuser on which the light collected by the light collection lens is incident.

6. An illuminator comprising:
the light source apparatus according to any one of the preceding claims; and
a homogenizing illumination system that illumination light outputted from the light source apparatus enters.

7. A projector comprising:
the illuminator according to claim 6;
a light modulator that modulates light from the illuminator in accordance with image information to form image light; and
a projection optical apparatus that projects the image light.
